Europäisches Patentamt

European Patent Office

Office européen des brevets

(11) Veröffentlichungsnummer : **0 167 059**
**B1**

(12) **EUROPÄISCHE PATENTSCHRIFT**

(45) Veröffentlichungstag der Patentschrift :
28.03.90

(21) Anmeldenummer : 85107559.8

(22) Anmeldetag : 19.06.85

(51) Int. Cl.⁵ : **G 01 R 33/38, H 01 F 7/20**

(54) Kernspin-Tomographiegerät.

(30) Priorität : 02.07.84 DE 3424304

(43) Veröffentlichungstag der Anmeldung :
08.01.86 Patentblatt 86/02

(45) Bekanntmachung des Hinweises auf die Patenterteilung : 28.03.90 Patentblatt 90/13

(84) Benannte Vertragsstaaten :
DE FR GB NL

(56) Entgegenhaltungen :
EP-A- 0 073 375
EP-A- 0 139 308
EP-A- 0 141 149
US-A- 3 564 398

(73) Patentinhaber : **Siemens Aktiengesellschaft**
**Wittelsbacherplatz 2**
**D-8000 München 2 (DE)**

(72) Erfinder : **Frese, Georg**
**Friedrich-Bauer-Strasse 11**
**D-8520 Erlangen (DE)**

EP 0 167 059 B1

## Beschreibung

Die Erfindung betrifft ein Kernspin-Tomographiegerät zur bildlichen Darstellung von Teilbereichen aus dem Innern eines Untersuchungsobjektes mit von einem Gehäuse umschlossenen Spulen zum Anlegen von magnetischen Grund- und Gradientenfeldern an das Untersuchungsobjekt und einer Antenne zum Erfassen der Auslenkung der Atomkerne des Untersuchungsobjektes aus ihrer Gleichgewichtslage durch hochfrequente magnetische Anregungsimpulse, sowie mit Mitteln zur Homogenisierung der Magnetfelder.

Ein Kernspin-Gerät ist in der US-A-3 564 398 beschrieben. Dieses Gerät eignet sich dazu, die Wasserstoffatomkerne des Untersuchungsobjektes auszulenken und deren Zurückschwingen in die Gleichgewichtslage zu erfassen. Für eine gute Spektrumsauflösung ist es dabei erforderlich, die auftretenden Grundfeldstörungen zu korrigieren. Hierzu ist bei dem bekannten Gerät eine Vielzahl von stromdurchflossenen Korrekturspulen, sogenannten Shim-Spulen, vorgesehen.

Der Erfindung liegt die Aufgabe zugrunde, für eine Korrektur von Grundfeldstörungen, also für die Homogenisierung der Magnetfelder, Mittel vorzusehen, die ohne zusätzliche Ströme auskommen.

Diese Aufgabe ist bei einem Gerät der eingangs genannten Art erfindungsgemäß dadurch gelöst, daß an den den Spulen zugeordneten Gehäuseteilen Halterungen zur Unterbringung von Eisenblechen vorgesehen sind, wobei durch eine geeignete Form, Größe, Anordnung und Anzahl von Eisenblechen die Magnetfelder homogenisiert werden.

Bei dem erfindungsgemäßen Gerät erfolgt die Homogenisierung der Magnetfelder mit Hilfe von Eisenblechen, ohne daß hierzu Shim-Spulen erforderlich sind oder unter Reduzierung der Anzahl der erforderlichen Shim-Spulen.

Eine besonders einfache Einstellung ist möglich, wenn die Eisenbleche in den Halterungen stapelbar sind. Durch geeignete Anzahl von Eisenblechen kann dabei eine gute Homogenisierung erreicht werden.

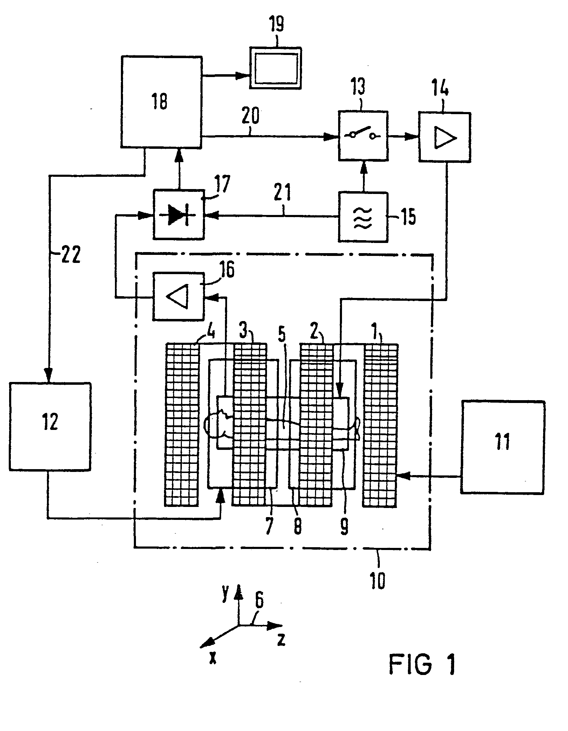

Zur Homogenisierung in x-, y- und z-Richtung (siehe Fig. 1) können die Halterungen streifenförmig an den Längsseiten des hohlzylindrischen Gehäuses parallel zur Gehäuse-Längsrichtung angebracht und/oder sternförmig an einer der Stirnwände des Gerätes angebracht sein. Werden an der Außenseite der Spulen magnetische Rückführungen entsprechend der europäischen Patentanmeldung EP-A-0 141 149 Prioritätsdatum: 19.09.83; Veröffentlichungsdatum: 15.05.85. Stand der Technik nach Artikel 54(3) EPÜ angeordnet, so ist eine Kompensation der durch diese magnetischen Rückführungen erzeugten Feldstörungen dadurch möglich, daß die Halterungen an einem den Untersuchungsraum umgebenden Gehäuseteil, insbesondere einem Kunststoffrohr, angebracht sind.

Die Erfindung ist nachfolgend anhand der Zeichnung näher erläutert. Es zeigen:

Fig. 1 ein Kernspin-Tomographiegerät zur Erläuterung des Erfindungsgedankens, und

Fig. 2 und 3 Einzelheiten des Kernspin-Tomographiegerätes gemäß Figur 1 mit Eisenblechen zur Magnetfeldhomogenisierung.

In der Figur 1 sind mit 1 und 2 sowie 3 und 4 Spulen gekennzeichnet, mit welchen ein magnetisches Gleichfeld $B_0$ erzeugt wird, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur 1 sind der Übersichtlichkeit halber nur Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht gezeichneten y-Gradientenspulen liegen parallel zum Körper 5 und oberhalb sowie unterhalb von ihm und die für das z-Gradientenfeld quer zu seiner Längsachse am Kopf- und am Fußende. Die Anordnung enthält außerdem noch eine zur Anregung der Kernresonanz und Aufnahme der Kernresonanzsignale dienende Antenne 9.

Die von einer strichpunktierten Linie 10 umgrenzten Komponenten 1 bis 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die sowohl zur Anregung als auch zur Aufnahme des Signales dienende Antenne 9 liegt einerseits über einen Modulator 13 und einen Sendeverstärker 14 an einem Hochfrequenzoszillator 15 und andererseits über einen Signalverstärker 16 und einen phasenempfindlichen Gleichrichter 17 an einem Prozeßrechner 18, von dem aus zur Ausgabe der Abbildung ein Bildschirmgerät 19 versorgt wird. Zur Steuerung der Anordnung sind außerdem noch Verbindungen 20, 21 und 22 zwischen dem Rechner 18 und dem Modulator 13 sowie dem Oszillator 15 und dem Gleichrichter 17 sowie dem Rechner 18 und der Gradientenstromversorgung 12 vorgesehen.

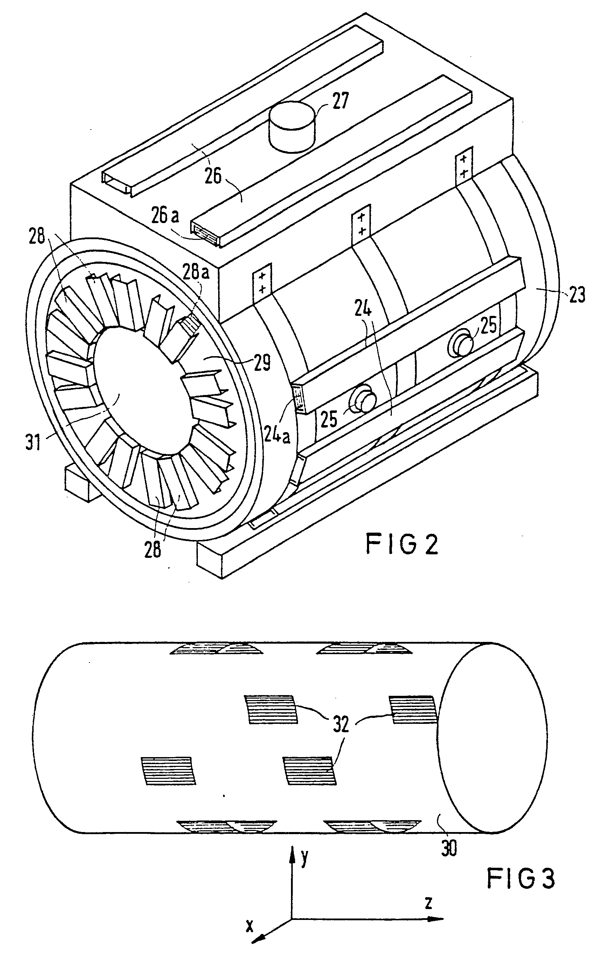

Aus der Figur 2 geht hervor, daß die Spulen 1 bis 4 von einem hohlzylindrischen Gehäuse 23 umgeben sind, das mit flüssigem Helium und flüssigem Stickstoff gefüllt ist, so daß die Spulen 1 bis 4 supraleitend sind. Zur Homogenisierung der Magnetfelder sind am Gehäuse 23 Halterungen für Eisenbleche vorhanden, in denen diese stapelbar sind. Diese Halterungen sind für die x-Richtung von zwei parallelen, parallel zur Längsrichtung des hohlzylindrischen Gehäuses 23 verlaufenden Aluminiumtaschen 24 gebildet, in die die Eisenbleche 24a in der erforderlichen Anzahl einschiebbar sind. Prinzipiell genügt auch eine solche Aluminiumtasche in der Mitte zwischen den Taschen 24 ; die gezeigte Konstruktion ist gewählt, damit zwischen den beiden Taschen 24 am Gehäuse 23 Anschlußstutzen 25 für Versorgungseinrichtungen angebracht werden können.

Zur Homogenisierung des Magnetfeldes in y-Richtung sind auf der Oberseite des Gehäuses 23 ebenfalls zwei parallele Taschen 26, die parallel zur Längsrichtung des Gehäuses 23 verlaufen und zur Aufnahme von Blechstreifen 26a dienen, vorgesehen. Der auf der Oberseite des Gehäuses 23 vorhandene Turm 27 dient dabei zur Versorgung des Gerätes mit verflüssigten Gasen und elektrischer Energie. Schließlich erfolgt die Homogenisierung des Magnetfeldes in z-Richtung durch Blechstreifen, die in Taschen 28 an der Stirnseite 29 des Gehäuses 23 liegen. Die Taschen 28 können wie die Taschen 24 und 26 aus Aluminiumblech bestehen und verlaufen vorzugsweise sternförmig oder ringförmig an der Stirnseite 29.

In Abhängigkeit von jeweiligen Gradientenverlauf werden die Taschen 28 an der Stirnseite 29 oder an der gegenüberliegenden Stirnseite des Gehäuses 23, die Taschen 26 an der Ober- oder an der gegenüberliegenden Unterseite und die Taschen 24 an der rechten oder an der gegenüberliegenden linken Seite des Gehäuses 23 vorgesehen.

Die Figur 3 zeigt ein Kunststoffrohr 30, das in das Gehäuse 23, und zwar in dessen zentrische Öffnung 31, einsetzbar ist. Sind am Gehäuse 23 entsprechend der deutschen Patentanmeldung P 33 33 755.1 magnetische Rückführungen aus Eisen vorgesehen, so kann zur Kompensation der dadurch erzeugten Inhomogenitäten an der Innenseite des Kunststoffrohres 30 in der in der Figur 3 dargestellten weise eine Anzahl von Eisenblechen 32 befestigt sein, die ebenfalls in Taschen liegen können.

Die in den Taschen 24, 26 und 28 stapelbaren Eisenbleche sind in der Figur 2 zum Teil schematisch dargestellt und mit 24a, 26a, 28a bezeichnet. Durch geeignete Wahl der Form, Größe, Anordnung und Anzahl dieser Eisenbleche 24a, 26a, 28a und auch der Eisenbleche 32 (Figur 3) ist dabei eine Homogenisierung der Magnetfelder im Rahmen der gewünschten Genauigkeit möglich.

**Patentansprüche**

1. Kernspin-Tomographiegerät zur bildlichen Darstellung von Teilbereichen aus dem Innern eines Untersuchungsobjektes (5) mit von einem Gehäuse (23) umschlossenen Spulen (1 bis 8) zum Anlegen von magnetischen Grund- und Gradientenfeldern an das Untersuchungsobjekt (5) und einer Antenne (9) zum Erfassen der Auslenkung der Atomkerne des Untersuchungsobjektes (5) aus ihrer Gleichgewichtslage durch hochfrequente, magnetische Anregungsimpulse, sowie mit Mitteln (24a, 26a, 28a, 32) zur Homogenisierung der Magnetfelder, dadurch gekennzeichnet, daß an den den Spulen (1 bis 8) zugeordneten Gehäuseteilen (23, 30) Halterungen (24, 26, 28) zur Unterbringung von Eisenblechen (24a, 26a, 28a, 32) vorgesehen sind, wobei durch eine geeignete Form, Größe, Anordnung und Anzahl von Eisenblechen (24a, 26a, 28a, 32) die Magnetfelder homogenisiert werden.

2. Kernspin-Tomographiegerät nach Anspruch 1, dadurch gekennzeichnet, daß die Eisenbleche (24a, 26a, 28a, 32) in den Halterungen (24, 26, 28) stapelbar sind.

3. Kernspin-Tomographiegerät nach Anspruch 1 oder 2, dadurch gekennzeichnet, daß die Halterungen (28) sternförmig an einer der Stirnwände (29) des Gerätes angebracht sind.

4. Kernspin-Tomographiegerät nach einem der Ansprüche 1 bis 3, dadurch gekennzeichnet, daß die Halterungen (24, 26) streifenförmig an den Längsseiten des hohlzylindrischen Gehäuses (23) parallel zur Gehäuse-Längsrichtung angebracht sind.

5. Kernspin-Tomographiegerät nach einem der Ansprüche 1 bis 4, dadurch gekennzeichnet, daß die Halterungen an einem den Untersuchungsraum (31) umgebenden Gehäuseteil (30) angebracht sind.

6. Kernspin-Tomographiegerät nach Anspruch 5, dadurch gekennzeichnet, daß der Gehäuseteil von einem Kunststoffrohr (30) gebildet ist.

7. Kernspin-Tomographiegerät nach Anspruch 6, dadurch gekennzeichnet, daß die Halterungen an der Innenfläche des Kunststoffrohres (30) angebracht sind.

**Claims**

1. Nuclear spin tomographic apparatus for pictorial representation of section regions from the interior of an object under investigation (5), with coils (1 to 8) surrounded by a housing (23) for applying magnetic basic fields and gradient fields on the object under investigation (5) and an antenna (9) for detecting the displacement of the atomic nuclei of the object under investigation (5) from their equilibrium position through high-frequency magnetic excitation pulses, as well as with means (24a, 26a, 28a, 32) for homogenization of the magnetic fields, characterised in that holders (24, 26, 28) are provided on housing parts (23, 30) associated with the coils to 8) for accommodating iron plates (24a, 26a, 28a, 32) wherein through a suitable shape, size, arrangement and number of iron plates (24a, 26a, 28a, 32) the magnetic fields are homogenised.

2. Nuclear spin tomographic apparatus according to claim 1, characterised in that the iron plates (24a, 26a, 28a, 32) are able to be stacked in the holders (24, 26, 28).

3. Nuclear spin tomographic apparatus according to claim 1 or 2, characterised in that the holders (28) are attached in the shape of a star on one of the end walls (29) of the apparatus.

4. Nuclear spin tomographic apparatus according to one of claims 1 to 3, characterised in that the holders (24, 26) are attached in the shape of a strip on the longitudinal sides of the hollow cylindrical housing (23) parallel to the housing longitudinal direction.

5. Nuclear spin tomographic apparatus according to one of claims 1 to 4, characterised in that holders are attached on one housing part (30) surrounding the examination chamber (31).

6. Nuclear spin tomographic apparatus according to claim 5, characterised in that the housing part is formed from a plastic tube (30).

7. Nuclear spin tomographic apparatus according to claim 6, characterised in that the holders are attached to the inner surface of the plastic tube (30).

## Revendications

1. Appareil de tomographie à spin nucléaire servant à former l'image de zones partielles de l'intérieur d'un objet à examiner (5), comportant des bobines (1 à 8) entourées par un boîtier (23) et servant à appliquer un champ magnétique de base et des champs magnétiques irrotationnels à l'objet à examiner (5), et une antenne (9) servant à détecter la déviation des noyaux atomiques de l'objet à examiner (5), à partir de leur position d'équilibre, au moyen d'impulsions d'excitation magnétique à haute fréquence ainsi que des moyens (24a, 26a, 27a, 32) servant à homogénéiser les champs magnétiques, caractérisé par le fait que sur les éléments (23, 30) du boîtier, associés aux bobines (1 à 8), il est prévu des supports (24, 26, 28) servant à supporter des tôles de fer (24a, 26a, 32), les champs magnétiques étant homogénéisés à l'aide d'une forme, de dimensions, d'une disposition et d'un nombre, appropriés, de tôles de fer (24a, 26a, 28a, 32).

2. Appareil de tomographie à spin nucléaire suivant la revendication 1, caractérisé par le fait que les tôles de fer (24a, 26a, 28a, 32) peuvent être empilées dans les supports (24, 26, 28).

3. Appareil de tomographie à spin nucléaire suivant la revendication 1 ou 2, caractérisé par le fait que les supports (28) sont installés selon une disposition en étoile sur l'une des parois frontales (29) de l'appareil.

4. Appareil de tomographie à spin nucléaire suivant l'une des revendications 1 à 3, caractérisé par le fait que les supports (24, 26) sont disposés sous la forme de bandes sur les côtés longitudinaux du boîtier cylindrique creux (23) parallèlement à la direction longitudinale de ce dernier.

5. Appareil de tomographie à spin nucléaire suivant l'une des revendications 1 à 4, caractérisé par le fait que les supports sont montés sur un élément (32) du boîtier, entouré par l'espace d'examen (32).

6. Appareil de tomographie à spin nucléaire suivant la revendication 1, caractérisé par le fait que l'élément du boîtier est formé par un tube en matière plastique (30).

7. Appareil de tomographie à spin nucléaire suivant la revendication 6, caractérisé par le fait que les supports sont montés sur la surface intérieure du tube en matière plastique (30).

FIG 1

FIG 2

FIG 3